Europäisches Patentamt

European Patent Office

Office européen des brevets

(19)

(11) Veröffentlichungsnummer: **0 002 472**
**B1**

(12) **EUROPÄISCHE PATENTSCHRIFT**

(45) Veröffentlichungstag der Patentschrift: 02.05.84

(21) Anmeldenummer: 78101529.2

(22) Anmeldetag: 02.12.78

(51) Int. Cl.³: **H 01 L 21/203,**
H 01 L 21/26,
H 01 J 37/30, C 30 B 23/02

(54) Vorrichtung und Verfahren zum Aufbringen von dotiertem Halbleitermaterial auf die Oberfläche eines Halbleitersubstrats.

(30) Priorität: 08.12.77 US 858486

(43) Veröffentlichungstag der Anmeldung:
27.06.79 Patentblatt 79/13

(45) Bekanntmachung des Hinweises auf die Patenterteilung:
02.05.84 Patentblatt 84/18

(84) Benannte Vertragsstaaten:
DE FR GB

(56) Entgegenhaltungen:
DE - A - 2 627 987
US - A - 3 434 894
US - A - 3 547 074
US - A - 3 563 809
US - A - 3 734 769
US - A - 3 865 625

VALVO BERICHTE, Band XVIII, Heft 1/2, 1974,
Hamburg, D. ECKSTEIN "Ionenimplantation als
Dotierverfahren in der Halbleitertechnologie.
Eine Übersicht"

(73) Patentinhaber: **International Business Machines
Corporation
Old Orchard Road
Armonk, N.Y. 10504 (US)**

(72) Erfinder: **Keller, John Howard
7 Dutchess Court
Newburgh New York 12550 (US)**
Erfinder: **McKenna, Charles Michael
7 Wedgewood Road
Fishkill New York 12524 (US)**
Erfinder: **Winnard, James Robert
8 Bellmore Drive
Poughkeepsie New York 12603 (US)**

(74) Vertreter: **Oechssler, Dietrich, Dr.rer.nat. Dipl.-
Chem.
Schönaicher Strasse 220
D-7030 Böblingen (DE)**

## Vorrichtung und Verfahren zum Aufbringen von dotiertem Halbleitermaterial auf die Oberfläche eines Halbleitersubstrats

Die Erfindung betrifft eine Vorrichtung zum Aufbringen von dotiertem Halbleitermaterial auf die Oberfläche eines Halbleitersubstrats, welche mindestens zwei Ionenquellen, Mittel, um Ionen aus den Ionenquellen zu extrahieren und dann weiterzutransportieren, und Mittel enthält, um Ionen des aufzubringenden Materials von Ionen nicht aufzubringenden Materials zu separieren und ein Verfahren zum Herstellen von Epitaxieschichten unter Verwendung der genannten Vorrichtung.

Das epitaxiale Aufwachsen von einkristallinem Silicium auf einem einkristallinen Siliciumsubstrat wird bei der Herstellung von integrierten Schaltkreisen in großem Umfang benutzt. Dieses epitaxiale Aufwachsen wird normalerweise dadurch bewirkt, daß Silicium aus der Dampfphase auf einem einkristallines Siliciumsubstrat abgeschieden wird. Damit dieses epitaxiale Aufwachsen des Siliciums aus der Dampfphase erfolgreich abläuft, werden überlicherweise Temperaturen oberhalb 1000°C und gewöhnlich in der Größenordnung von 1150°C benutzt, damit das epitaxial abgeschiedene Silicium einkristallin wird. Wenn dieses Abscheiden aus der Dampfphase bei Temperaturen unterhalb 1000°C durchgeführt wird, wird das Aufwachsen einer einheitlich einkristallinen Epitaxiestruktur aus der Dampfphase unmöglich, da polykristalline Bereiche in der Struktur zu erscheinen beginnen.

Zwar sind die Hochtemperatur-Epitaxieprozesse, welche Temperaturen in der Größenordnung von 1100 bis 1200°C benutzen, sehr effektiv gewesen im Herstellen einkristalliner Epitaxieschichten. Es treten bei ihnen jedoch ein Nebeneffekt, nämlich die Ausdiffusion bzw. das Ausgasen, auf. Dieses Phänomen tritt auf, wenn die heißen Siliciumdämpfe mit dem Siliciumsubstrat bei so hohen Temperaturen in Kontakt kommen. Wenn das Substrat Bereiche mit die Leitfähigkeit bestimmenden Verunreinigungen, wei z. B. $N^+$- oder $P^+$-Bereiche enthält, werden die die Leitfähigkeit bestimmenden Atome aus diesen Bereichen relativ weit in die abgeschiedene einkristalline Siliciumschicht hinein ausgasen oder ausdiffundieren. Solange die Technik überlicherweise Epitaxieschichten benutzte, deren Dicken in der Größenordnung zwischen 2 und 6 $\mu$m lag, stellte diese Ausdiffusion normalerweise kein Problem dar. Nachdem nun aber die Technik sich in die Richtung von dünneren und immer dünneren Epitaxieschichten bewegt, deren Dicken unter 2 $\mu$m liegen, und bei zukünftigen Technologien vermutlich in der Größenordnung von 500 nm liegen werden, wird das Problem der Ausdiffusion beim epitaxialen Aufwachsen aus der Gasphase beachtlich, weil solche ausdiffundierten Bereiche sich im wesentlichen durch die gesamte Dicke solch dünner Epitaxieschichten erstrecken werden.

Es kommt hinzu, daß, je weiter sich die Technik der integrierten Schaltkreise in die Richtung von Bauelementen bewegt, welche aktive Bereiche mit sowohl lateralen als auch vertikalen Abmessungen in der Größenordnung von 1 $\mu$m oder weniger haben, sich das Bedürfnis in der Technik verstärkt, Methoden an der Hand zu haben, mit denen sich Bauelemente herstellen lassen, in deren aktiven Bereichen steuerbare vertikale Verteilungen von die Leitfähigkeit bestimmenden Verunreinigungen vorliegen. Die gegenwärtig, beispielsweise in der Diffusion und beim epitaxialen Aufwachsen, angewandten Hochtemperaturverfahren zum Einführen solcher Verunreinigungen machen die genaue Kontrolle von Verunreinigungskonzentrationen unmöglich, und zwar deshalb, weil die Verunreinigungen zu wandern beginnen, wenn sie solchen hohen Temperaturen ausgesetzt werden. Es kommt hinzu, daß auch dann, wenn die Verunreinigungen mittels Ionenimplantation bei niedrigeren Temperaturen eingeführt werden, die vertikale Verteilung, welche sich in einem mittels Ionenimplantation hergestellten Bereich einstellt, nicht voll kontrollierbar sein wird, was auf Dotierungsstoff-Durchdringungs-Phänomene während konventioneller Operationen, zu denen z. B. das Tempern oder Vielfachimplantationen gehören, zurückzuführen ist.

Ein Verfahren, bei dem versucht wird, dotierte Halbleiterdichten auf einem anderen Weg zu erzeugen, ist in der US-Patentschrift 3 734 769 beschrieben. Bei diesem Verfahren wird Material auf ein Substrat mittels eines Ionenstrahls aufgebracht. Die dabei verwendete Vorrichtung enthält mehrere Ionenquellen. Die Strahlen, die aus den verschiedenen Ionenquellen austreten, können auf einen Punkt fokussiert werden. Es ist dabei aber nicht möglich, gleichzeitig mehrere Materialien, beispielsweise das Halbleitermaterial und ein Dotierungsmaterial, auf das Halbleitermaterial aufzubringen. Dies bedeutet mit anderen Worten, daß—um in dem gewählten Beispiel zu bleiben—es nur möglich ist, abwechselnd Schichten von Halbleitermaterial und Dotierungsstoff aufzubringen. Die erforderliche homogene Verteilung des Dotierungsstoffs im Halbleitermaterial kann nur durch eine nachfolgende Temperaturbehandlung erreicht werden. Die in der US-Patentschrift verwendete Vorrichtung erlaubt es auch nur, Ionenstrahlen mit einem sehr kleinen—größenordnungsmäßig 5 $\mu$m—Durchmesser auf dem Substrat, und zwar mit hoher Energie, auftreffen zu lassen.

Auch in der US-Patentschrift 3 563 809 ist ein Verfahren beschrieben, bei dem Ionenstrahlen auf ein Substrat einwirken. Die dabei verwendete Vorrichtung weist auch mehrere Ionenquellen auf, aus denen aber nicht gleichzeitig Ionen auf das Substrat geleitet werden können. Die Ionen aus den verschiedenen Quellen werden beispielsweise zum Dotieren des Substrats, zum Umsetzen einer Oberflächenschicht des Substrats, wobei eine Passivierungsschicht entsteht, und zum Abtragen von Substratmaterial verwendet. In der US-Patentschrift 3 563 809 ist zwar nicht angegeben, mit welcher Energie die Ionen auf das Substrat auftreffen, aus der Tatsache jedoch, daß die Ionen implantiert werden oder abtragend wirken sollen, ist zu schließen, daß die Energie hoch sein muß. Die bei den verwendeten Verfahren angewandte Vorrichtung fokussiert den Ionenstrahl auf einen Punkt des Substrats.

Es ist die Aufgabe der Erfindung, eine Vorrichtung zum Aufbringen von dotiertem Halbleitermaterial auf Halbleitersubstrate und ein Verfahren auzugegeben, um unter Verwendung der genannten Vorrichtung auf Halbleitersubstraten Epitaxieschichten aus dotiertem Halbleitermaterial mit einem festgelegten vertikalen Dotierungsprofil reproduzierbar zu erzeugen, wobei die Halbleitersubstrate nur mäßigen Temperaturen ausgesetzt werden.

Diese Aufgabe wird mit einer Vorrichtung der eingangs genannten Art mit den Merkmalen des kennzeichnenden Teil des Patentanspruchs 1 und mit einem Verfahren der eingangs genannten Art mit den Merkmalen des kennzeichnenden Teils des Patentanspruchs 8 gelöst.

Eine Vorrichtung, bei welcher Ionenstrahlen aus einer mit einer Lochplatte verschlossenen Ionenquelle extrahiert werden, ist zwar in der DE—OS 26 27 987 beschrieben, jedoch erlaubt es die Vorrichtung nicht, mehrere Ionenarten gleichzeitig auf das Substrat auftreffen zu lassen. Dies ist auch nicht erforderlich, da die Vorrichtung bei der Ionenimplantation eingesetzt wird und nicht dafür gedacht ist, Schichten, welche aus mindestens zwei Materialien bestehen, auf Substratoberflächen aufzuwachsen. Als weiterer Unterschied zwischen der erfindungsgemäßen und der in der deutschen Offenlegungsschrift verwendeten Vorrichtung kommt hinzu, daß bei der letzteren mittels der Lochplatte diskrete Ionenstrahlen erzeugt werden und nicht—wie bei der erfindungsgemäßen Vorrichtung—*ein* relativ breiter Ionenstrahl mit über den Strahlenquerschnitt homogener Ionenverteilung.

Die Erfindung erlaubt es, integrierte Schaltungen mit einer Vielzahl von übereinanderliegenden Halbleiterbereichen zu erzeugen, in welchen festgelegte Verteilungen der die Leitfähigkeit bestimmenden Verunreinigungen vorliegen. Es ist mit der Erfindung auch möglich, integrierte Schaltungen mit vertikalen bipolaren Bauelementen zu erzeugen, welche dadurch ausgezeichnet sind, daß ihre Basis-, Emitter- und Kollektorbereiche erwünschte, genau festgelegte Verteilungen der die Leitfähigkeit bestimmenden Verunreinigungen aufweisen. Die Erfindung ist insbesondere auch sehr gut dafür geeignet, Epitaxieschichten mit sehr genau festgelegten Verteilungen der die Leitfähigkeit bestimmenden Verunreinigungen auf einem einkristallinen Halbleitersubstrat bei Temperaturen, welche wesentlich unter 1000°C liegen, zu erzeugen. Diese relativ niedrigen Temperaturen verhindern die bei den bekannten Epitaxieverfahren auftretende Ausdiffusion von Verunreinigungen aus dem Substrat. Deshalb ist die Dotierungskonzentration in der aufwachsenden Schicht nur von genau festgelegten und gut steuerbaren Bedingungen abhängig und ist deshalb leicht genau zu kontrollieren. Mit der erfindungsgemäßen Vorrichtung ist es möglich, auf ein Halbleitersubstrat, welches beispielsweise aus Silicium besteht, einen Strahl von Ionen des Halbleitermaterials mit einer Energie von weniger als 0,5 keV auftreffen zu lassen und dabei gleichzeitig einen Strahl von Ionen der gewünschten, die Leitfähigkeit bestimmenden Verunreinigung mindestens auf einen Bereich der Substratoberfläche, welcher auch von den Halbleiterionen getroffen wird, zu richten, wobei eine Schicht aus Halbleitermaterial, welche die gewünschte, die Leitfähigkeit bestimmende Verunreinigung enthält, auf der Halbleiteroberfläche gebildet wird.

Die erzeugten Ionenstrahlen haben einen Durchmesser von bis zu 15 cm. Mit der Vorrichtung lassen sich in vorteilhafter Weise Ionenstrahlen mit einer kombinierten Stromdichte in der Größenordnung von mindestens 1 mA/cm² an der Halbleiteroberfläche erzeugen. Die Vorrichtung ist in vorteilhafter Weise dafür geeignet, sowohl einen Strahl von Ionen des Halbleitermaterials, welches auf dem Halbleitersubstrat aufgewachsen werden soll, als auch einen Strahl aus Ionen der die Leitfähigkeit bestimmenden Verunreinigungen, welche in die aufwachsende Schicht eingebaut werden sollen, zu erzeugen. Im Falle der Verwendung nur eines Massenanalysatormagneten ist dieser in vorteilhafter Weise so ausgebildet, daß er in der Lage ist, den Strahl aus den Halbleiterionen und den Strahl aus den Verunreinigungsionen zu koaxial verlaufenden Strahlen zusammenzuführen und dann auf das Halbleitersubstrat, auf welchem die Schicht aus Halbleitermaterial aufwachsen soll, zu richten.

Die mittels des erfindungsgemäßen Verfahrens erzeugte Schicht ist noch nicht einkristallin. Der einkristalline Zustand wird aber in vorteilhafter Weise sehr einfach dadurch erhalten, daß man das Substrat mit der aufgebrachten Schicht auf eine Temperatur im Bereich zwischen etwa 550 und etwa 900°C zwischen etwa 30 und etwa 90 Minuten lang erhitzt. Auf diese Weise liegen die bei dem erfindungsgemäßen Verfahren angewandten Temperaturen wesentlich unter der Temperatur (1000°C), oberhalb der es schwierig wird, die Verteilung der die Leitfähigkeit bestimmenden Verunreinigungen in der aufwachsensen Epitaxieschicht zu steuern. Aus diesem Grund ist bei der Anwendung der Erfindung die Verteilung der die Leitfähigkeit bestimmenden Verunreinigungen in der vertikalen Richtung leicht steuerbar.

Das erfindungsgemäße Verfahren läßt sich in vorteilhafter Weise mit den "Abhebe" ("lift-off")-Techniken kombinieren, wodurch es möglich wird, auf einer Halbleiteroberfläche selektiv Epitaxieschichtbereiche mit genau festgelegten lateralen Abmessungen zu erzeugen.

Weitere vorteilhafte Ausgestaltungen der erfindungsgemäßen Vorrichtung und des erfindungsgemäßen Verfahrens ergeben sich aus den Unteransprüchen.

Die Erfindung wird an Hand von durch Zeichnungen erläuterten Ausführungsbeispielen beschrieben.

Es zeigen:

Fig. 1 in schematischer Darstellung eine Ionenstrahlvorrichtung entsprechend einer Ausführungsform der vorliegenden Erfindung.

Fig. 2 in schematischer Darstellung eine Ionenstrahlvorrichtung entsprechend einer anderen Ausführungsform der vorliegenden Erfindung und

Fig. 3A—3H in schematischen Querschnittsansichten einen Teil einer integrierten Schaltung in verschiedenen Stadien der Herstellung eines vertikalen bipolaren Transistors gemäß der vorliegenden Erfindung.

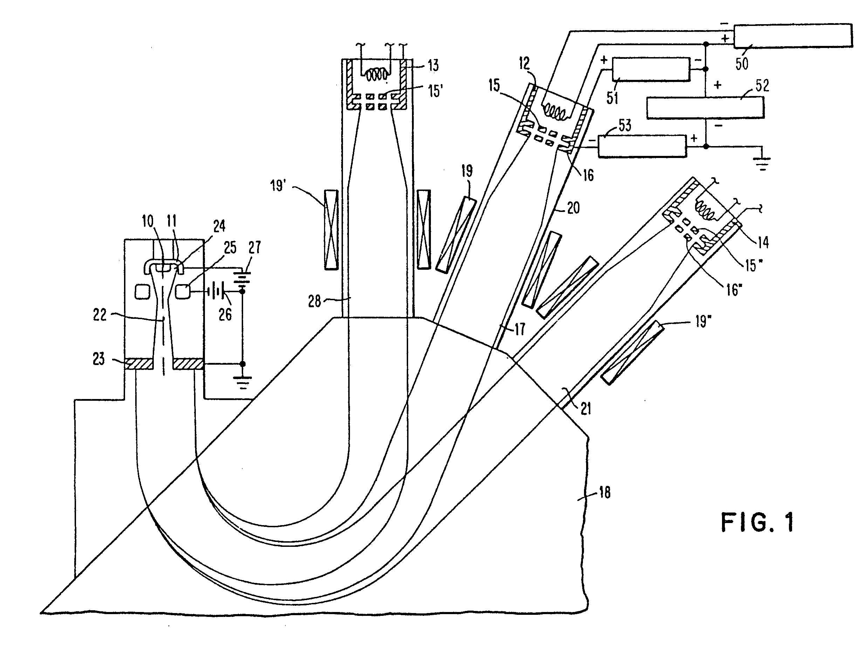

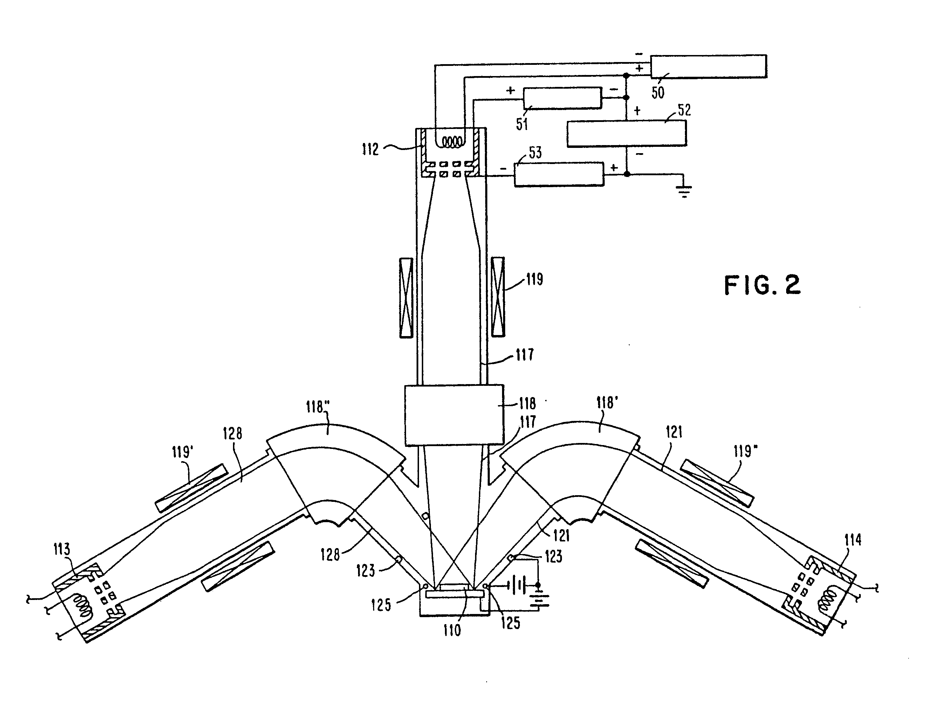

Die Fig. 1 und 2 zeigen in schematischer Darstellung zwei Ausführungsformen gemäß der vorliegenden Erfindung. In der in der Fig. 1 gezeigten Vorrichtung werden der Strahl aus Halbleiterionen und der Strahl aus den Ionen der die Leitfähigkeit bestimmenden Verunreinigungen in voneinander unabhängigen Quellen erzeugt, aber dann zu einem einzigen Massenanalysatormagneten geleitet, welcher so ausgestattet ist, daß beim Auftreffen auf das Substrat die Strahlen der genannten Halbleiterionen und der Ionen der die Verunreinigung bestimmenden Verunreinigungen im wesentlichen koaxiale Bahnverläufe entlang einer festgelegten Strahlachse haben. In der in der Fig. 2 gezeigten Vorrichtung haben die Strahlen der Halbleiterionen bzw. der Ionen der die Leitfähigkeit bestimmenden Verunreinigungen nicht nur separate Quellen, sondern auch separate Massenanalysatoren, welche so ausgestattet sind, daß sie die aus ihnen austretenden Strahlen auf einander überlappende Bereiche auf dem Substrat richten.

Die Vorrichtung gemäß der Erfindung wird zunächst an Hand der Fig. 1 besprochen. Eine Epitaxieschicht soll auf der Oberfläche des Siliciumplättchens 10, welches sich auf dem Substrathalter 11 befindet, gebildet werden. Zu dem Apparat gehört eine Quelle 12 zum Erzeugen der Siliciumionen und eine Quelle 13 für Verunreinigungen vom N-Typ, wie z. B. Arsen, und eine Quelle 14 für Verunreinigungen vom P-Typ, wie z. B. Bor. Aus Bequemlichkeit und um die Konstruktion der Vorrichtung zu erleichtern, können die Quellen 13 und 14 für die die Leitfähigkeit bestimmenden Verunreinigungen im wesentlichen die gleiche Struktur wie die Quelle 12 für die Siliciumionen, welche detaillierter besprochen werden wird, haben. Bei dieser detaillierten Besprechung sollte beachtet werden, daß, sofern nichts anderes gesagt ist, die speziellen Ionenimplantationselemente, welche im Zusammenhang mit der vorliegenden Erfindung benutzt werden, eine konventionelle Ausbildung haben, ähnlich wie die Teile, welche in den Vorrichtungen vorhanden sind, welche beispielsweise in dem US-Patent 3 756 862 oder in dem Buch "Ion Beams" von R. G. Wilson u.a., welches 1973 im Verlag Wiley-Interscience erschienen ist, beschrieben sind. Zwar kann die Quelle 12 in der Fig. 1, ebenso wie die Quellen 13 und 14, aus irgendeiner üblichen Quelle mit hoher Dichte bestehen. Die in den Ausführungsformen gezeigte Quelle ist eine Elektronenstoßquelle mit heißem Heizdraht (hot filament electron impact source), welche im üblichen Bogenentladungsmodus operiert. Um Ionen auf der Oberfläche des Plättchens 10 abzuscheiden, ist es wünschenswert, Strahlen zu verwenden, welche am Ort der Auftrefffläche relativ breite laterale Abmessungen haben, d. h., daß die Strahlen Durchmesser von bis zu 15 cm haben. Um eine hohe Stromdichte von mindestens 1 mA/cm² bei solch relativ breiten Strahlen aufrechtzuerhalten, wird es bevorzugt, Quellen mit einer Ausgangsplatte zu verwenden, welche bei den Quellen 12, 13 und 14 mit den Bezugszahlen 15, 15' bzw. 15" bezeichnet wird und eine Vielzahl von Öffnungen aufweist. Diese, eine Vielzahl von Öffnungen aufweisende Ausgangsplatte kann eine Struktur haben, wie sie in dem Artikel von J. H. Keller im IBM Technical Disclosure Bulletin, September 1975, Seiten 1057 bis 1058 beschrieben ist, mit der Ausnahme, daß die eine Vielzahl von Öffnungen aufweisende Ausgangsplatte oder Quellenelektrode in der erfindungsgemäßen Vorrichtung bevorzugt flach und nicht gewölbt ist.

Eine typische Ausbildung einer solchen flachen, eine Vielzahl von Öffnungen aufweisenden Platte für die Verwendung in der Ionenstrahltechnologie ist im US-Patent 3 238 715 gezeigt. Um ein einleuchtendes Beispiel zu geben, sei gesagt, daß eine typische, eine Vielzahl von Öffnungen aufweisende Platte, welche für die Vorrichtung gemäß der Erfindung brauchbar ist, einen Durchmesser von 10 cm und ungefähr 800 Öffnungen hat, von denen jede einen Durchmesser in der Größenordnung von 2 mm hat. Der Ionenstrahl wird aus der Quelle 12 mittels einer Extraktionselektrode 16 extrahiert, welche eine Vielzahl von Öffnungen aufweist, welche den Öffnungen in der Quellenelektrode 15 entsprechen und im wesentlichen mit diesen koinzidieren. Die Extraktionselektrode 16, welche auch als die Beschleunigungselektrode bekannt ist, wird mittels der Beschleunigungsspannungsversorgung 53 auf einem negativen Potential gehalten, während die Quellenelektrode 15 auf einem positiven Potential gehalten wird. Die Spannungs- bzw. Energieversorgungen für den Heizdraht, die Bogenentladung und das Extrahieren sind schematisch in die Fig. 1 eingezeichnet und mit den Bezugzeichen 50 bis 52 versehen. Der aus der Quelle 12 extrahierte Strahl von Halbleiterionen wird entlang einem Strahlengang 17 in einen Massenanalysatormagneten geleitet. Um zu verhindern, daß der Strahl 17, welcher ab dem Austritt aus der Quelle breiter wird, an die Wände 20 der Vorrichtung gestreut wird, ist eine magnetische Linse 19 vorhanden, welche dazu dient, den Strahl 17 zu kondensieren, d.h. zu fokussieren, so daß nach der Fokussierung der Strahl als ein im wesentlichen paralleler Strahl in den Massenanalysator 18 eintritt. Gleichzeitig mit diesem Betreiben der Halbleiterionenquelle 12 erzeugt eine der Quellen 13 oder 14 einen gleichartigen Strahl aus Ionen von die Leitfähigkeit bestimmenden Verunreinigungen. Zu Illustrationszwecken wollen wir annehmen, daß die Quelle 14 einen Strahl von Ionen solcher Verunreinigungen produziert, welche eine Leitfähigkeit vom N-Typ erzeugen (N-Typ-Verunreinigung). Beispielsweise haben Arsenionen diesen Effekt. Der Strahl 21 aus Arsenionen wird aus der Quellenelektrode 15 mittels der Beschleunigungselektrode 16 extrahiert, mittels der magnetischen Linse 19 fokussiert und dann in den Massenanalysator 18 geleitet. Es sei angemerkt, daß zu beiden Quellen 13 und 14 (nicht gezeigte) Energieversorgungen gehören, welche den zu der Quelle 12 gehörenden Energieversorgungen äquivalent sind. Der Massenanalysatormagnet 18 dient einerseits dazu, um die Halbleiterionen in dem Strahl 17 von anderen Ionen in diesem Strahl und die Arsenionen im Strahl von anderen Verunreinigungen in diesem Strahl zu trennen und andererseits die Strahlen 17 und 21 beim Austritt aus dem Analysator 18 auf im wesentlichen koaxiale Bahnverläufe entlang der Strahlachse 22, welche senkrecht auf dem Plättchen 10 stehen, zu bringen. In diesem Zusammenhang wirkt die mit einer Öffnung versehene Massenseparatorplatte 23 mit dem Massenanalysator 18 zusammen, um die oben beschriebenen koaxialen Strahlen zu definieren. Zusätzlich bewirkt der Analysator 18, daß sich die Strahlen verkleinern bzw. konvergieren, so daß die Strahlen 17 und 21 beim Verlassen des Analysators 18 schmäler sind als beim Eintritt in den Analysator.

Damit der Massenanalysatormagnet 18 effektiv funktionieren kann, sollten die Strahlen 17 und 21, welche auf den Magneten mittels der Extraktionselektroden und 16 und 16″ gerichtet werden, bevorzugt Energieniveaus zwischen 1 und 10 keV haben. Um jedoch effektiv eine Epitaxieschicht aus Halbleitermaterial, wie z. B. Silicium, welches mit Arsen dotiert ist, auf dem Substrat 10 aufzuwachsen, sollte der kombinierte Strahl 24, welcher auf die Auftrefffläche auftrifft, bevorzugt ein Energieniveau unter 0,5 keV haben. Um ein solches Energieniveau beim Auftreffen auf das Plättchen 10 zu gewährleisten, sind Verzögerungsmittel, wie z. B. die elektrostatisch wirkende Verzögerungslinse 25, vorhanden, welche auf den Strahl einwirken, bevor er auf das Plättchen 10 auftrifft. Die Energieversorgungen 26 und 27 halten das Verzögerungslinsentor 25 bezüglich der den Strahl definierenden Platte 23 auf einem negativen Potential, wodurch der Strahl auf die Auftrefffläche gerichtet bleibt, aber auch auf einem noch negativeren Potential bezüglich des Plättchens 10. Auf diese Weise hat das Plättchen 10 ein positives Potential bezüglich der den Strahl definierenden Platte 23. Auf diese Weise sorgen das Verzögerungslinsentor 25 und die Auftrefffläche 10 für einen auf die Strahlen wirkenden Verzögerungslinseneffekt. Mit dieser Anordnung können die gleichzeitig auf das Plättchen 10 gerichteten Strahlen auf ein Potential unter 0,5 keV verzögert werden. Ganz ähnlich ist der Ablauf, wenn eine Halbleiterschicht auf dem Substrat 10 abgeschieden werden soll, welche mit einer Verunreinigung dotiert ist, welche, wie z. B. Bor, eine Leitfähigkeit vom P-Typ erzeugt. In diesem Fall wird der von der Quelle 13 produzierte Strahl 28 mit dem Strahl 17 aus Halbleiterionen im wesentlichen in der gleichen Weise kombiniert wie der Strahl 21 mit dem Strahl 17 kombiniert worden ist. Auf diese Weise erhält man eine Schicht aus Halbleitermaterial vom P-Typ. Man kann also, indem man die die Leitfähigkeit bestimmende Verunreinigung, welche mit dem Strahl aus Halbleiterionen, welche abgeschieden werden, kombiniert wird, selektiv alterniert, eine integrierte Schaltungsstruktur erzeugen, welche alternierend Schichten aus Halbleitermaterial vom P-Typ und vom N-Typ und natürlich P/N-Übergänge an der Grenzfläche solcher Schichten aufweist.

An Hand der Fig. 2 wird nun eine weitere Ausführungsform der Vorrichtung gemäß der Erfindung beschrieben. Anstelle eines einzigen Massenanalysators, wie er in der in der Fig. 1 gezeigten Vorrichtung benutzt worden ist, benutzt die in der Fig. 2 gezeigte Vorrichtung je einen Massenanalysator für jeden der drei Strahlen. Bei dieser Anordnung sind die Strahlen aus Halbleiterionen und aus Ionen der die Leitfähigkeit bestimmenden Verunreinigung, welche auf das Plättchen 110 auftreffen, nicht koaxial, vielmehr werden die Strahlen auf der Auftrefffläche überlappen, so daß eine Epitaxieschicht aus dem Halbleitermaterial, welche die ausgewählte, die Leitfähigkeit bestimmende Verunreinigung enthält, auf dem Halbleitersubstrat 110 abgeschieden werden kann. Die Quelle 112 für die Halbleiterionen ebenso wie die Quellen 113 und 114 für die die Leitfähigkeit bestimmenden Ionen haben im wesentlichen dieselbe Struktur wie die entsprechenden Quellen 12, 13, und 14 in der Fig. 1. Die mit den Bezugzeichen 50 bis 53 versehenen Kästchen haben dieselben Bedeutungen wie die so bezeichneten Kästchen in der Fig. 1. Ebenso funktionieren die zur Strahlverkleinerung dienenden magnetischen Linsen 119, 119' und 119" in derselben Weise wie die ensprechenden Verkleinerungslinsen 19, 19' und 19" in der Fig. 1. In der Fig. 2 werden der Strahl 117 aus Halbleiterionen und die Strahlen 121 bzw. 128 aus den Ionen der die Leitfähigkeit bestimmenden Verunreinigungen auf die diskreten Analysatoren 118, 118' und 118" gerichtet.

Wie bei der oben beschriebenen Vorrichtung ist es bei dem Arbeiten mit der in der Fig. 2 gezeigten Vorrichtung vorteilhaft, einen der Strahlen von Ionen der die Leitfähigkeit bestimmenden Verunreinigung, d.h. entweder Strahl 121 aus Ionen der Verunreinigung vom N-Typ oder Strahl 128 aus Ionen der Verunreinigung vom P-Typ, zu erzeugen und solch einen Strahl gleichzeitig mit dem Strahl 117 aus Halbleiterionen auf das Plättchen 110 auftreffen zu lassen. Die diskreten Massenanalysatormagneten 118' und 118" verfahren in der üblichen Weise entweder mit dem Strahl 121 aus Ionen der Verunreinigung vom N-Typ oder mit dem Strahl 128 aus Ionen vom P-Typ. Der Strahl 117 aus Halbleiterionen geht durch den anderen Analysator, nämlich den ExB-Analysator, hindurch. Zwar kann die Funktion des Analysators 118 bequem von einem Massenanalysatormagneten, beispielsweise vom Typ des Massenanalysators 118', übernommen werden, es kann aber auch ein ExB-Analysator für diese Funktion in bequemer Weise verwendet werden. Ein ExB-Analysator oder -separator ist ein Massenseparator, der manchmal als Geschwindigkeitsfilter bezeichnet wird. Dieses Gerät benutzt ein elektrisches Feld, welches sowohl auf dem magnetischen Feld als auch auf dem Strahlengang senkrecht steht. Unter diesen Bedingungen wird eine ausgewählte Ionenklasse in gerader Richtung durch den Separator durchpassieren, während Teilchen mit einer anderen Masse oder einer anderen Geschwindigkeit abgelenkt werden. Diese "In-Gerader-Richtung-Durch"-Charakteristik des ExB-Filters ist für die in der Fig. 2 gezeigte Vorrichtungsstruktur vorteilhaft, weil das Substrat 110 sich im wesentlichen in Richtung der Achse der Quelle 112 befindet. Auf diese Weise können die Ionen aus Halbleitermaterial, welche selektiert und auf dem Plättchen 110 abgeschieden werden sollen, in gerader Richtung durchpassieren. ExB-Analysatoren sind im Detail in dem oben erwähnten Buch "Ion Beams" von R. G. Wilson auf den Seiten 213 bis 227 beschrieben. Wie oben im Zusammenhang mit dem in der Fig. 1 gezeigten Analysator beschrieben worden ist, bewirken die Analysatoren 118, 118' und 118", daß sich die Strahlen verkleinern, d.h., daß sie konvergieren, so daß die Strahlen aus Halbleiterionen oder aus Ionen der die Leitfähigkeit bestimmenden Verunreinigung diese Analysatoren etwas schmäler verlassen, als sie beim Eintritt in die Analysatoren waren.

Die Strahlen werden aus den zugehörigen Quellen bevorzugt mit einer Energie im Bereich zwischen etwa 1 und etwa 10 keV extrahiert. Wie aber bereits oben im Zusammenhang mit der Fig. 1 dargelegt worden ist, sollten die überlappenden Strahlen, d.h. die Strahlen 117 und 121, beim Auftreffen auf das Plättchen bevorzugt eine Energie unterhalb 0,5 keV haben, damit effektiv eine Epitaxieschicht aus Halbleitermaterial, wie z. B. Silicium, welches mit Arsen dotiert ist, auf dem Substrat 110 abgeschieden werden kann. Solche Energieniveaus werden mittels Verzögerungsmitteln erreicht, welche ähnlich sind denjenigen Verzögerungsmitteln, welche in der in der Fig. 1 gezeigten Vorrichtung vorhanden sind. Die den Strahl definierende Platte 123 wird auf einem Spannungsniveau gehalten, welches ähnlich ist demjenigen, auf dem die Platte 23 in der Fig. 1 liegt. Die elektrostatische Verzögerungslinse 125 funktioniert in äquivalenter Weise wie die Verzögerungslinse 25 in der Fig. 1 und bewirkt wie diese, daß der Strahl verzögert wird, bevor er auf das Plättchen 110 auftrifft.

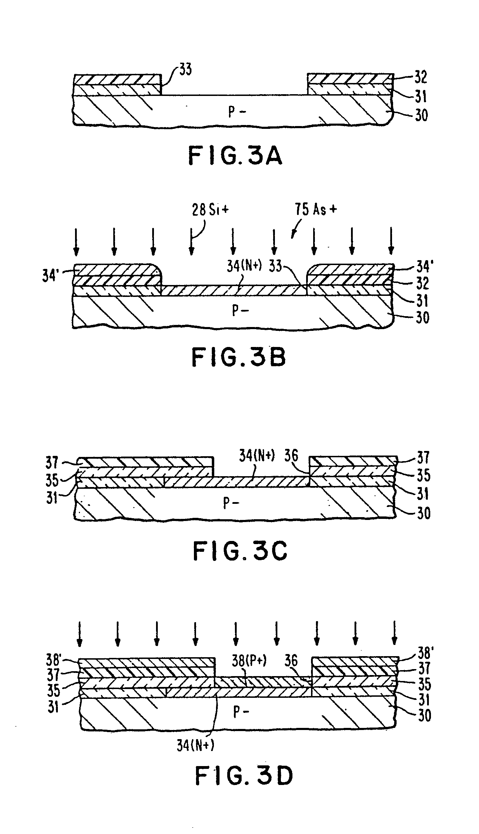

An Hand der Fign. 3A bis 3H soll nun das erfindungsgemäße Verfahren im Zusammenhang mit der Erzeugung eines Teils einer integrierten Schaltung, welcher einen vertikalen bipolaren Transistor enthält, besprochen werden. Diese Prozeßbeschreibung dient in erster Linie dazu, das Verfahren zu verdeutlichen und es sei klargestellt, daß das erfindungsgemäße Verfahren dazu benutzt werden kann, um integrierte Schaltkreise zu erzeugen, in welchen Bauelemente vorhanden sind, welche irgendwelche Kombinationen von abgeschiedenen Epitaxieschichten enthalten.

Auf einem Plättchen 30 aus P-Material, d.h. einem Siliciumsubstrat, welches einen spezifischen Widerstand von 10 $\Omega$/cm hat, wird eine übliche passivierende, elektrisch isolierende Schicht 31 aus einem Material, welches Siliciumnitrid sein kann, aber im vorliegenden Fall aus Siliciumdioxid besteht, erzeugt. Die Siliciumdioxidschicht kann mittels irgendeines bekannten Verfahrens, zu denen die thermische Oxidation des Substrates 30 oder das chemische Niederschlagen aus der Dampfphase gehören, erzeugt werden und hat eine Dicke von 1000 nm. Unter Verwendung einer Photolackmaske 32, welche aus irgendeinem bekannten negativen oder positiven Photolackmaterial bestehen kann und eine Dicke in der Größenordnung von 2500 nm hat, und unter Anwendung bekannter, bei der Herstellung von integrierten Schaltungen üblicher lithographischer Fabrikationstechniken, wie sie beispielsweise in dem US-Patent 3 539 876 beschrieben sind, wird eine Öffnung 33 in der Schicht 31 erzeugt.

Als nächstes wird, wie die Fig. 3B zeigt, unter Verwendung entweder der in der Fig. 1 oder der in der Fig. 2 gezeigten Vorrichtung das mas-

kierte Substrat einer Ionenabscheidung von Silicium ($^{28}$Si$^+$)- und von Arsen ($^{75}$As$^+$)-Ionen unterworfen. Die Siliciumionendosis liegt dabei bei $5 \times 10^{18}$ Ionen/cm². Die Arsendosis kann natürlich entsprechend dem gewünschten Subkollektorprofil variiert werden. Beispielsweise kann eine Arsenionendosis von $10^{16}$ Ionen/cm² angewandt werden, um eine Siliciumschicht 34 vom N-Typ mit einer maximalen Konzentration von $10^{21}$ Atomen/cm³ und einer Dicke von 1000 nm durch Abscheiden in der Öffnung 33 zu erzeugen. Ein Teil 34' der Siliciumschicht wird auf der Oberfläche der Photolackmaske 32 abgeschieden. Als nächstes wird unter Anwendung bekannter "Abhebe" (lift-off)-Techniken die Photolackmaske 32 entfernt, wobei beim Abheben die Teile 34' der N$^+$-Schicht mitentfernt werden. Es sollte in diesem Zusammenhang darauf hingewiesen werden, daß die "Abhebe"-Techniken wohl bekannt sind. Das US-Patent 3 873 361 gibt einen guten Überblick über solche "Abhebe"-Techniken. Unter Anwendung solcher bekannter "Abhebe"-Techniken können die Schichten 32 und 34' entfernt werden, indem die in der Fig. 3B gezeigte Struktur in eines der üblichen Lösungsmittel für Photolack getaucht wird. Die üblichen Photolacklösungsmittel, welche bei solchen "Abhebe"-Techniken eingesetzt werden können, sind in dem US-Patent 3 873 361 in der Spalte 5, Zeilen 45ff aufgeführt.

Anschließend wird, wie die Fig. 3C zeigt, eine zweite Schicht 35 aus Siliciumdioxid, welche ungefähr 200 nm dick ist, erzeugt. In dieser Schicht wird eine Öffnung 36 unter Anwendung der üblichen photolithographischen Techniken erzeugt, wie sie bei der Herstellung integrierter Schaltkreise angewandt werden, und wie sie weiter oben besprochen worden sind.

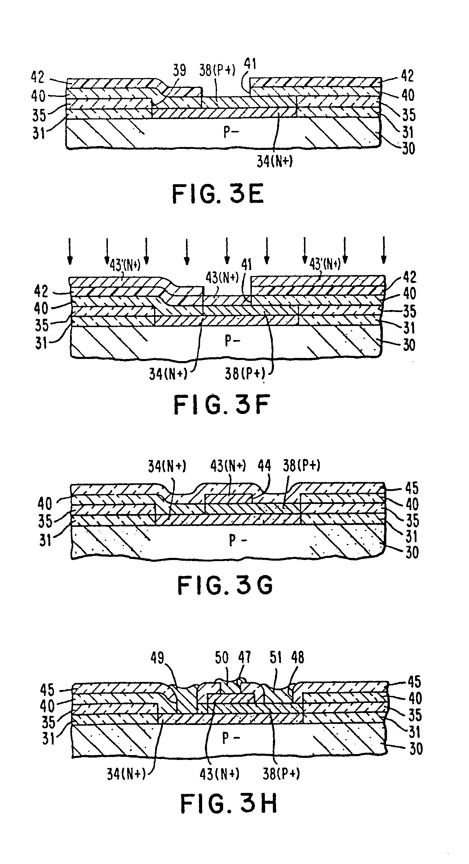

Als nächstes wird, wie die Fig. 3D zeigt, eine Siliciumschicht vom P$^+$-Typ aufgebracht, welche 200 nm dick ist und eine P$^+$-Konzentration von $5 \times 10^{18}$ Atomen/cm³ hat. Während dieser Erzeugung, bei der entweder die in der Fig. 1 oder die in der Fig. 2 gezeigte Vorrichtung verwendet wird, ist die Photolackschicht 37, welche bei der Herstellung der Öffnung 36 auf photolithographischem Wege benutzt wurde, noch vorhanden. Die Ionenabscheidung wird durchgeführt mit Dosen von Silicium ($^{28}$Si$^+$)-Ionen in der Größenordnung von $5 \times 10^{18}$ Ionen/cm². Die Bordosis kann je nach dem gewünschten Basisprofil variiert werden. Beispielsweise kann eine Bor($^{11}$B$^+$)-Ionen-Dosis in der Größenordnung von $10^{14}$ Ionen/cm² angewandt werden. Während des Abscheidens der P$^+$-Siliciumschicht 38 in der Öffnung 36 wird auf der Photolackschicht 37 eine P$^+$-Schicht 38' abgeschieden. Anschließend werden die Photolackschicht 37 und die P$^+$-Siliciumschicht 38' mittels der oben beschriebenen "Abhebe"-Techniken entfernt. Durch die Schicht 35 wird mittels üblicher lithographischer Techniken eine Öffnung 39 in dem Bereich geätzt, in welchem der Kollektorkontakt, d.h. der Kontakt zu dem N$^+$-Bereich 34, später erzeugt werden soll, und dann wird eine dritte Siliciumdioxidschicht 40 auf der Oberfläche der Struktur, einschließlich der Öffnung 39, abgeschieden. Durch die Siliciumdioxidschicht 40 hindurch wird unter Verwendung der Photolackmaske 42 unter Anwendung der oben beschriebenen üblichen Techniken eine Öffnung 41 erzeugt. Die dann vorliegende Struktur zeigt die Fig. 3E.

Anschließend wird, wie die Fig. 3F zeigt, unter Anwendung entweder der an Hand der Fig. 1 oder der an Hand der Fig. 2 beschriebenen Vorrichtung eine Schicht 43 aus N$^+$-Silicium in der Öffnung 41 abgeschieden. Die Dicke der Schicht 43 liegt in der Größenordnung von 200 nm und hat eine N$^+$(Arsen)-Konzentration von $10^{20}$ Atomen/cm³. Dann wird die oben beschriebene "Abhebe"-Technik wiederholt, um die Photolackschicht 42 und die N$^+$-Schicht 43', welche sich auf dieser Photolackschicht abgeschieden hat, zu entfernen.

Dann wird eine Öffnung 44 in dem Bereich, wo später der Basiskontakt gebildet werden soll, durch die Siliciumdioxidschicht 40 hindurch geätzt. Anschließend wird auf der gesamten Oberfläche der Struktur eine vierte Siliciumdioxidschicht 45 abgeschieden.

An diesem Punkt sind der N$^+$-Bereich 34, aus welchem später der Kollektor entstehen soll, der P$^+$-Bereich 38, aus welchem später die Basis entstehen soll, und der N$^+$-Bereich 43, aus welchem später der Emitter entstehen soll, noch nicht einkristallin. Deshalb wird, um diese Bereiche in den einkristallinen Zustand zu überführen, die in der Fig. 3G gezeigte Struktur einer bei Temperaturen zwischen 550 und 900°C durchgeführten Wärmebehandlung unterworfen, welche zwischen 30 und 90 Minuten dauert. Bei einer typischen Durchführung der Wärmebehandlung wird 30 Minuten lang auf 900°C erhitzt.

Als nächstes werden, wie die Fig. 3H zeigt, unter Anwendung bekannter lithographischer Ätztechniken die Kollektor-Emitter- und Basiskontaktöffnungen 46, 47 und 48 durch die Siliciumdioxidschichten hindurch erzeugt. Anschließend werden der Kollektorkontakt 49, der Emitterkontakt 50 und der Basiskontakt 51, welche alle aus Metall bestehen, zu dem N$^+$-Kollektorbereich 34, zu dem N$^+$-Emitterbereich 43 bzw. dem P$^+$-Basisbereich 38 erzeugt. Die Kontakte 49, 50 und 51, welche unter Anwendung der üblichen Fabrikationstechniken für integrierte Schaltkreise, wie sie z. B. im US-Patent 3 539 876 beschrieben sind, hergestellt werden können, sind normalerweise mit einem (nicht gezeigten) Metallisierungsmuster, von dem sie ein Teil sind, verbunden. Das Metallisierungsmuster wird auf der Siliciumdioxidschicht 45 gebildet und verbindet die Bauelemente in der integrierten Schaltungsstruktur.

**Patentansprüche**

1. Vorrichtung zum Aufbringen von dotiertem Halbleitermaterial auf die Oberfläche eines Halbleitersubstrats (10, 110), welche mindestens zwei Ionenquellen (12, 112, 13, 113, 14, 114) Mittel, um Ionen aus den Ionenquellen (12, 112, 13, 113, 14, 114) zu extrahieren und dann weiterzutransportieren und Mittel (18, 118, 118', 118" enthält, um Ionen des aufzubringenden Materials von Ionen des nicht aufzubringenden Materials zu separieren, dadurch gekennzeichnet, daß die Ionenquellen (12, 112, 13, 113, 14, 114) mit einer eine Vielzahl von Öffnungen aufweisenden Austrittsplatte (15, 15', 15") versehen sind, daß magnetische Linsen (19, 19', 19", 119, 119', 119") vorhanden sind, um die aus den Extraktionsmitteln austretenden Ionen zu fokussieren und so auszurichten, daß sie als im wesentlichen parallel verlaufende Strahlen auf den Mitteln zum Separieren auftreffen, daß mindestens ein Massenanalysatormagnet (18, 118', 118") oder mindestens ein ExB-Analysator (118) vorhanden ist, um unerwünschte Ionen zu separieren und zum Erreichen, daß die gleichzeitig durch ihn hindurch geführte, aus mindestens zwei Ionenquellen (12, 112, 13, 113, 14, 114) stammenden Ionenstrahlen festgelegter Energie mit einem Durchmesser von bis zu 15 cm mindestens auf einem Bereich des Halbleitersubstrats (10, 110) in homogener Vermischung auftreffen und daß mindestens eine Verzögerungslinse (25, 125) zum Verzögern der Ionenstrahlen vor dem Auftreffen auf dem Substrat vorhanden ist.

2. Vorrichtung nach Anspruch 1, gekennzeichnet durch ihre Verwendung zur Erzeugung von Ionenstrahlen mit einer Stromdichte an der Halbleiteroberfläche in der Größenordnung von mindestens 1 mA/cm².

3. Vorrichtung nach Anspruch 1 oder 2, dadurch gekennzeichnet, daß als Mittel zum Extrahieren und Weitertransportieren der Ionen eine, eine Vielzahl von mit den Öffnungen in den Austrittsplatten (15, 15', 15") in etwa fluchtenden Öffnungen aufweisende und auf einem bezüglich der Quellen (12, 13, 14, 112, 113, 114) negativen Potential liegende Elektroden (16, 16") dienen und daß als Mittel zum Separieren der Ionen und um sie kontrolliert auf das Substrat (10) zu richten, entweder ein einziger Massenanalysatormagnet (18) oder je ein Massenanalysatormagnet (118', 118") bzw. ein ExB-Analysator (118) für jeden Ionenstrahl Anwendung finden.

4. Vorrichtung nach einem der Ansprüche 1 bis 3, dadurch gekennzeichnet, daß im Fall der Verwendung nur eines Massenanalysatormagneten (18) dieser so ausgebildet ist, daß er die aus mindestens zwei Quellen (12, 13, 14) stammenden Ionenstrahlen in einen koaxialen, auf das Substrat (10) zulaufenden Bahnverlauf bringt.

5. Vorrichtung nach einem der Ansprüche 1 bis 4, dadurch gekennzeichnet, daß zum Definieren der Strahlabmessungen senkrecht zur Strahlrichtung und zum Abbremsen der Ionen vor dem Auftreffen auf das Substrat (10, 110) außer der Verzögerungslinse (25, 125) eine den Ionenstrahl bzw. die Ionenstrahlen definierende, eine Öffnung aufweisende Platte (23, 123) vorhanden ist, wobei die Verzögerungslinse (25, 125) sowohl bezüglich der Platte (23, 123) als auch bezüglich des Substrates (10, 110) auf einem negativen Potential und das Substrat (10, 110) auf einem positiveren Potential als die Platte (23, 123) liegt.

6. Vorrichtung nach einem der Ansprüche 1 bis 5, dadurch gekennzeichnet, daß die Mittel zum Separieren so ausgebildet sind, daß die Ionenstrahlen in ihnen schmäler werden.

7. Verfahren zum Erzeugen von Epitaxieschichten aus dotiertem Halbleitermaterial auf einem Halbleitersubstrat unter Verwendung einer Vorrichtung nach einem der Ansprüche 1 bis 6, dadurch gekennzeichnet, daß ein Strahl von Ionen des aufzuwachsenden Materials und ein Strahl von Ionen des einzubauenden Dotierungsstoffes mit einer Energie von weniger als 0,5 keV gleichzeitig auf mindetens einen Bereich der Oberfläche des Substrats (10, 110) gerichtet wird und daß nach dem Aufwachsen einer Schicht gewünschter Dicke das Substrat mit der Schicht auf eine Temperatur im Bereich zwischen etwa 550 und etwa 900°C zwischen etwa 30 und etwa 90 Minuten lang erhitzt wird.

8. Verfahren nach Anspruch 7 oder 8, dadurch gekennzeichnet, daß als Halbleitermaterial Silicium und als einzubauende Dotierungsstoffe Materialien aus der Gruppe Bor, Arsen und Phosphor verwendet werden.

9. Verfahren nach einem der Ansprüche 7 bis 9, dadurch gekennzeichnet, daß das Abscheiden der Schicht bei Raumtemperatur durchgeführt wird.

10. Verfahren nach einem der Ansprüche 7 bis 10, dadurch gekennzeichnet, daß vor dem Abscheiden der Schicht auf dem Substrat eine Photolackmaske erzeugt wird, welche die Substratbereiche addeckt, auf welchem keine Schicht aufwachsen soll, daß daraufhin die Schicht abgeschieden wird, daß anschließend die Photolackmaske einschließlich der auf ihr abgeschiedenen Schicht entfernt wird und schließlich die Wärmebehandlung durchgeführt wird.

11. Verfahren nach einem der Ansprüche 7 bis 11, dadurch gekennzeichnet, daß vor der Wärmebehandlung das Aufbringen der Schicht—gegebenenfalls einschließlich des Erzeugens und des nachträglichen Entfernens einer Photolackmaske—einoder mehrmals wiederholt wird, wobei die Dotierungsstoffe so ausgewählt werden, daß sich in den aufwachsenden Schichten Leifähigkeiten vom P- und N-Typ abwechseln.

**Revendications**

1. Dispositif pour le dépôt d'un matériau semiconducteur dopé sur la surface d'un substrat semiconducteur (10, 110), comprenant au moins deux sources d'ions (12, 112, 13, 113, 14, 114), des moyens pour l'extraction des ions des sources (12, 112, 13, 113, 14, 114), puis leur transport, et des moyens (18, 118, 118', 114") pour séparer les ions du matériau à déposer des ions du matériau non à déposer, ledit dispositif étant caractérisé en ce que les sources d'ions (12, 112, 13, 113, 14, 114) sont munies d'une plaque de sortie (15, 15', 15") présentant de nombreuses ouvertures; des lentilles magnétiques (19, 19', 19", 119, 119', 119") sont prévues pour focaliser les ions sortant des moyens d'extraction et les aligner de façon qu'ils atteignent des moyens de séparation sous forme de faisceaux pratiquement parallèles; au moins un aiment analyseur de masse (18, 118', 118") ou au moins un analyseur ExB (118) est prévu pour séparer les ions gênants et assurer que les faisceaux ioniques d'énergie fixée, le traversant simultanément et provenant d'au moins deux sources d'ions (12, 112, 13, 113, 14, 114), atteignent sous forme d'un mélange homogène une zone au moins du substrat semiconducteur (10, 110), avec un diamètre maximal de 15 cm; et une lentille décélératrice (25, 125) au moins est prévue pour ralentir les faisceaux ioniques avant leur impact sur le substrat.

2. Dispositif selon revendication 1, caractérisé par son utilisation pour la production de faisceaux ioniques avec une densité de courant sur la surface du semiconducteur de l'ordre de 1 mA/cm² au minimum.

3. Dispositif selon une des revendications 1 ou 2, caractérisé en ce que les moyens d'extraction et de transport des ions sont constitués par une électrode (16, 16") présentant de nombreuses ouvertures sensiblement alignées sur celles des plaques de sortie (15, 15', 15") et portée à un potentiel négatif par rapport aux sources (12, 13, 14, 112, 113, 114); et les moyens utilisés pour séparer les ions puis les diriger de façon contrôlée sur le substrat (10) sont constitués soit par un seul aimant analyseur de masse (18), soit par un aimant analyseur de masse (118', 118") ou un analyseur ExB (118) pour chaque faisceau ionique.

4. Dispositif selon une quelconque des revendications 1 à 3, caractérisé en ce que dans le cas d'utilisation d'un seul aimant analyseur de masse (18) ce dernier est réalisé de façon à diriger les faisceaux ioniques, provenant de deux sources (12, 13, 14) au moins, sur une trajectoire coaxiale aboutissant au substrat (10).

5. Dispositif selon une quelconque des revendications 1 à 4, caractérisé en ce que pour définir les dimensions du faisceau perpendiculairement à son sens et pour freiner les ions avant leur impact sur le substrat (10, 110), une plaque (23, 123) comportant une ouverture et définissant le ou les faisceaux ioniques est prévue en plus de la lentille décélératrice (25, 125), qui par rapport à la plaque (23, 123) et au substrat (10, 110) est portée à un potentiel négatif, le substrat (10, 110) se trouvant à un potentiel plus positif que celui de la plaque (23, 123).

6. Dispositif selon une quelconque des revendications 1 à 5, caractérisé en ce que les moyens de séparation sont réalisés de façon à réduire la largeur des faisceaux ioniques.

7. Procédé pour la production de couches épitaxiées d'un matériau semiconducteur dopé sur un substrat semiconducteur, à l'aide d'un dispositif selon une quelconque des revendications 1 à 6, ledit dispositif étant caractérisé en ce qu'un faisceau d'ions du matériau à faire croître et un faisceau d'ions du dopant à incorporer sont dirigés simultanément, avec une énergie inférieure à 0,5 kéV, sur une zone au moins de la surface du substrat (10, 110); et après la croissance d'une couche de l'épaisseur souhaitée, le substrat portant cette couche est chauffé pendant environ 30 à environ 90 minutes à une température comprise entre environ 550 et environ 900°C.

8. Procédé selon une des revendications 7 ou 8, caractérisé par l'emploi comme matériau semiconducteur de silicium et comme dopants à incorporer de matériaux du groupe bore, arsenic et phosphore.

9. Procédé selon une quelconque des revendications 7 à 9, caractérisé en ce que le dépôt de la couche s'effectue à la température ambiante.

10. Procédé selon une quelconque des revendications 7 à 10, caractérisé par la production, avant le dépôt de la couche sur le substrat, d'un masque de photorésist, qui couvre les zones du substrat sur lesquelles aucune couche ne doit croître; la couche est ensuite déposée; puis le masque de photorésist est éliminé avec la couche déposée sur lui; et le traitement thermique est ensuit effectué.

11. Procédé selon une quelconque des revendications 7 à 11, caractérisé en ce qu'avant le traitement thermique, le dépôt de la couche—le cas échéant avec la production, puis la suppression d'un masque de photorésist—est répété une ou plusieurs fois, les dopants étant choisis de façon que les conductions P et N alternent dans les couches croissantes.

**Claims**

1. Device for depositing doped semiconductor material on the surface of a semiconductor substrate (10, 110) containing at least two ion sources (12, 112, 13, 113, 14, 114), means to extract ions from the ion sources (12, 112, 13, 113, 14, 114) and to retransport them, and means (18, 118, 118', 118") to separate ions of the material to be applied from ions of the material not to be applied, characterized in that the ion sources (12, 112, 13, 113, 14, 114) contain a multi-apertured exit plate (15, 15', 15"), that magnetic lenses (19, 19', 19", 119, 119', 119") are provided for focussing the ions exiting from the extracting means, and to align them in such a manner that they impinge as substantially parallel beams on the separating means, that at least one mass analyser magnet (18, 118', 118"), or at least one ExB-analyser (118) is provided to separate undesired ions and to make sure that the ion beams which pass therethrough simultaneously, which originate from at least two ion sources (12, 112, 13, 113, 14, 114), which are of a predetermined energy, and which have a diameter of up to 15 cm impinge on at least one region of the semiconductor substrate (10, 110) in a homogeneous mixture, and that at least one retarding lens (25, 125) is provided to retard the ion beams prior to their impinging on the substrate.

2. Device as claimed in claim 1, characterized by its use for producing ion beams with a current density on the semiconductor surface in the order of at least 1 mA/cm².

3. Device as claimed in claim 1 or 2, characterized in that as means for extracting and transporting the ions an electrode which has a multitude of apertures approximately flush with the apertures in the exit plates (15, 15', 15"), and which is applied to a potential that is negative with respect to the sources (12, 13, 14, 112, 113, 114) is used, and that as a means for separating the ions and for directing them to the substrate (10) under control, either one single mass analyser magnet (18), or one respective mass analyser magnet (118', 118"), or an ExB-analyser (118) is used for each ion beam.

4. Device as claimed in any one of claims 1 to 3, characterized in that if only one mass analyser magnet (18) is used it is designed in such a manner that it directs the ion beams originating from at least two sources (12, 13, 14) into a coaxial path extending toward the substrate (10).

5. Device as claimed in any one of claims 1 to 4, characterized in that for defining the beam dimensions vertically to the beam direction, and for decelerating the ions prior to their impinging on the substrate (10, 110), apart from the retarding lens (25, 125), a plate (23, 123) defining the ion beam or beams, respectively, and having one opening is provided, the retarding lens (25, 125) being on a negative potential with respect to the plate (23, 123) as well as with respect to the substrate (10, 110), and the substrate (10, 110) being applied to a more positive potential than the plate (23, 123).

6. Device as claimed in any one of claims 1 to 5, characterized in that the separating means are designed in such a manner that the ion beams are narrowing therein.

7. Method of producing epitaxial layers of doped semiconductor material on a semiconductor substrate, using a device as disclosed in any one of claims 1 to 6, characterized in that a beam of ions of the material to be grown, and a beam of ions of the doping substance to be introduced are directed with an energy of less than 0.5 keV simultaneously to at least one region of the surface of the substrate (10, 110), and that following the growing of a layer of the respective thickness the substrate is heated with the layer to a temperature between approximately 550 and approximately 900°C, for about 30 and about 90 minutes.

8. Method as claimed in any one of claims 7 or 8, characterized in that as semiconductor material silicon is used, and as doping substances to be introduced materials selected from the group containing boron, arsenic and phosphorus are used.

9. Method as claimed in any one of claims 7 to 8, characterized in that the deposition of the layer is effected at room temperature.

10. Method as claimed in any one of claims 7 to 9, characterized in that prior to the deposition of the layer onto the substrate a photoresist mask is made which covers those substrate regions where no layer is to grow, that subsequently the layer is deposited, that subsequently the photoresist mask including the layer deposited thereon is removed, and that finally heat processing is effected.

11. Method as claimed in any one of claims 7 to 10, characterized in that prior to the heat processing the deposition of the layer—if necessary including the producing and subsequent removal of a photoresist mask—is repeated one or several times with the dopants being selected in such a manner that conductivities of the P- and N-type alternate in the growing layers.

FIG. 1

FIG.2

FIG. 3A

FIG. 3B

FIG. 3C

FIG. 3D

FIG. 3E

FIG. 3F

FIG. 3G

FIG. 3H